# EUROPEAN PATENT APPLICATION

(11) **EP 4 793 986 A1**
(43) Date of publication of application: **19.08.2026**
(21) Application number: 25157966.0
(22) Date of filing: 14.02.2025
(51) Int. Cl.: H01J 37/32, H01J 37/34, H01L 21/687

(54) **WAFER HOLDING SYSTEM WITH A WAFER CHUCK, A MAGNETRON SPUTTER WITH SAID WAFER HOLDING SYSTEM AND A METHOD FOR SPUTTER DEPOSITION USING A MAGNETRON SPUTTER**

(71) Applicant: Polyteknik A/S, 9750 Øster Vrå (DK)
(72) Inventor: LARSEN, Jens William, 9330 Dronninglund (DK)
(74) Representative: Patrade A/S

(57) **Abstract**

A method for sputter deposition using a magnetron sputter with a target, said method comprising the acts of:
- establishing a vacuum zone in a vacuum chamber (110), and in the vacuum zone:
- providing a wafer chuck (10) slidable arranged on at least one rail (30);
- arranging a wafer (90) with a deposition surface (92) on the wafer chuck (10) with said deposition surface (92) facing the target;
wherein the wafer chuck (10) is configured for rotating the wafer in a rotational plane (122) substantially parallel to the deposition surface (92) and wherein the method comprises an act of
- sputtering target material onto the wafer (90) when arranged on the wafer chuck (10), while rotating the wafer and moving the wafer chuck (10) linearly back and forth along the rail (30) in a direction substantially parallel to the rotational plane.

## Description

### Field of the Invention

The invention relates to a method for sputter deposition using a magnetron sputter and a wafer holding system with a wafer chuck configured for linear and rotational movement for improvement of resistivity of the sputtered layers. The invention furthermore relates to a magnetron sputter comprising wafer holding system and preferably a temperature control system.

### Background of the Invention

Magnetron sputtering is a well-known technique for thin film depositing. A magnetron sputter uses magnets for trapping charged particles to be forced into the target, thereby generating a physical vapour.

The magnetic field is believed to affect the depositing of the thin film of metal compound oxide or metal compound nitrides or metal compound oxide nitrides or metal compound carbides or metal compound oxide nitrides carbides. These metal compounds may be used for forming metal thin films.

The resulting resistivity or sheet resistance of the thin film will have a pattern as a function of the magnetic field. In many cases the thin film will have a torus- or donut-shaped pattern in the resistivity or sheet resistance. In many cases a uniform resistivity or sheet resistance is desired, but the resistivity or sheet resistance may in many cases vary up to a factor of more than 3-4 and in some cases a factor of 10. Thus, there is a need for an improved magnetron sputter capable of sputtering thin film while minimising the mean variation of the resistivity or sheet resistance. The diameter of the wafer is preferably as large as possible as it is more efficient and will lower production time and costs. The variance increases with the diameter of the wafer. The variance is too large for a 100 mm diameter wafer, which size is mostly used in R&D. 200 mm, 300 mm, or 450 mm diameter wafers are sizes used in commercial production of thin film transistors and these wafers will have an even greater variance making magnetron sputtering unusable for commercial production of thin film transistors or thin films of metal compound oxide or metal compound nitrides or metal compound oxide nitrides or metal compound carbides or metal compound oxide nitrides carbides.

Likewise, similar variance pattern is observed for some piezoelectric like e.g. PZT.

Metals such as NbxTi(1-x)N has been proposed to replace cobber/aluminium as interconnects on chips with 4 nm nodes or less such as 3 nm or 2 nm or 1.8 nm or 1.4 nm or less. Preferably, the transition-metal interconnects such as NbxTi(1-x)N interconnects are deposited using magnetron sputtering however this will require a much more uniform sheet resistance than what magnetron sputters for commercial production can achieve.

A Pokhrel et al (2023) "Towards Enabling Two Metal Level Semi-Damascene Interconnects for Superconducting Digital Logic: Fabrication, Characterization and Electrical Measurements of Superconducting NbxTi(1-x)N" proposes NbxTi(1-x)N with 0.5 < x < 0.8 has been proposed for use as interconnects in quantum computers due to a high critical temperate of 17 K compared to 9.2 K of Nb. However, the previously mentioned variance in sheet resistance is due to a variance in the material properties and thus the critical temperature is also affected.

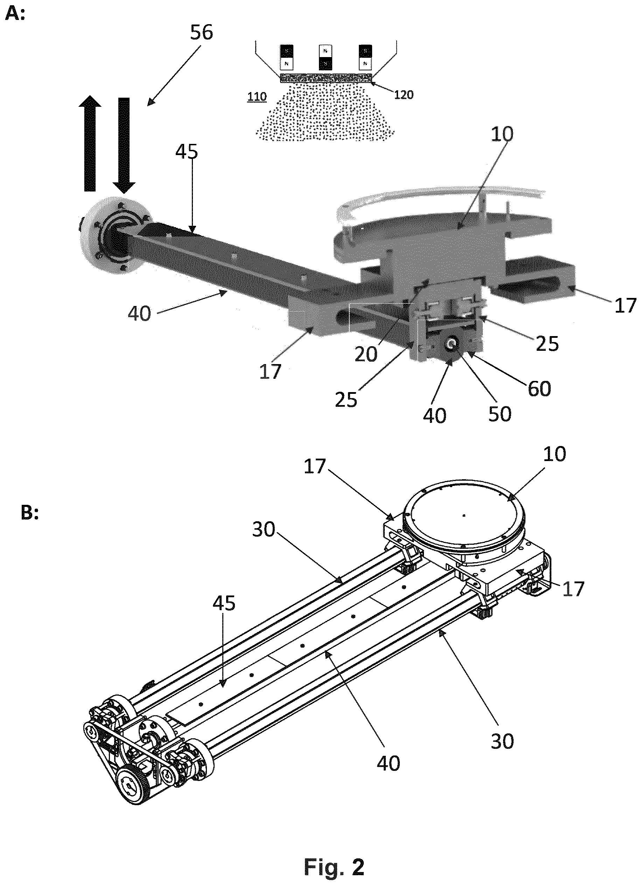

DJ Thoen et al (2016) "Superconducting NbTiN Thin Films with Highly Uniform Properties over a Ø 100 mm diameter Wafer" proposes to mount a Ø 100 mm wafer on a rotating drum passing the sputter target during deposition. The resulting NbTiN Thin Film has uniform properties as can be observed by figure 2 in the article such as a uniform critical temperature and sheet resistance. However, a Ø100 mm wafer is not viable for commercial production as larger diameters are preferred and this makes the drum solution unwanted. The drum requires a large vacuum chamber compared to other solutions as the drum vacuum chamber scales with radius squared and a Ø 400 mm wafer would require 16 times larger vacuum chamber compared to the vacuum chamber used in the article. The time needed for achieving vacuum scales with the vacuum chamber volume and thus the drum solution is not viable for commercial production as the entire system also becomes larger requiring more space in the clean room.

Thus, there is a need for a commercially viable magnetron system capable of producing metal compound thin films with high uniform properties such as uniform sheet resistance.

### Object of the Invention

It is an object of the invention to provide a method for sputter deposition and a wafer holding system supporting this method for achieving metal compound thin films with high uniform properties such as uniform sheet resistance.

It is an object of the invention to provide a temperature control system for a wafer chuck and a magnetron sputter including the temperature control system.

It is an object of the invention to provide a method for sputter deposition using a magnetron sputter.

### Description of the Invention

An object of the invention is achieved by a method for sputter deposition using a magnetron sputter with a target, said method comprising the acts of:
- establishing a vacuum zone in a vacuum chamber, and in the vacuum zone:
- providing a wafer chuck slidable arranged on at least one rail;
- arranging a wafer with a deposition surface on the wafer chuck with said deposition surface facing the target;
wherein the wafer chuck is configured for rotating the wafer in a rotational plane substantially parallel to the deposition surface and wherein the method comprises an act of
- sputtering target material onto the wafer when arranged on the wafer chuck, while rotating the wafer and moving the wafer chuck linearly back and forth along the rail in a direction substantially parallel to the rotational plane.

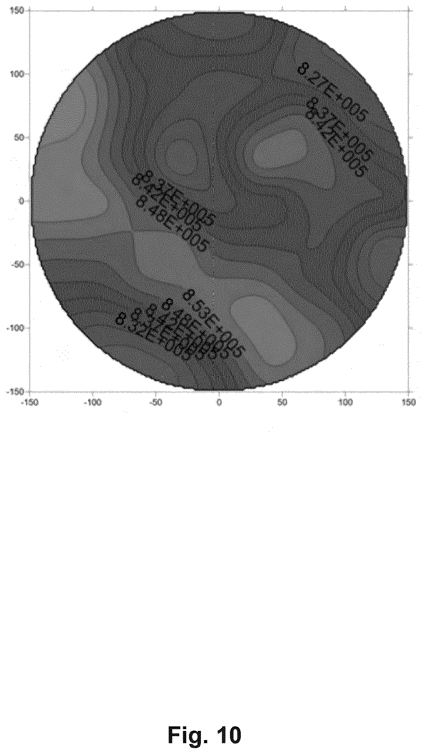

The combination of using a rotational and a linear movement of the wafer chuck and hence the wafer limits the pattern effect from magnetron magnets as the wafer will move in relation to the magnetic field's lines similar to the drum solution described in the Background of the Invention. Figure 10 discloses a measured sheet resistance measured using a four-point probe. The figures disclose that the variance is about 1.8 % which is a substantial improvement from the prior art as described in the Background of the Invention.

Below in table 1, experimental data is listed using the above method and a used target. Five different samples have been made with wafer IDs: 2, 3, 5, 6 and 9. For samples 2, 3 and 5 a combination of rotational and linear movement has been used under the deposition sputtering process, while only linear movement has been used for samples 6 and 9.

A general improvement in the uniform sheet resistance is achieved by implementing the combination of linear and rotational movement during the sputtering process.

**Table 1**

| Sample ID | Rotation | Scan speed (mm/s) | Ar (sccm) | Rs Avg (kOhm) | CV%(1-Sigma) |
|---|---|---|---|---|---|
| Used Test Bourne 2 | Yes | 31 | 26.60 | 802 903 | 8.26 (Redo) 6.5 |
| Used Test Bourne 3 | Yes | 31 | 26.26 | 753 | 10.2 |
| Used Test Bourne 5 | Yes | 31 | 23.27 | 762 | 9.6 |
| Used Test Bourne 6 | No | 31 | 28.15 | 747 | 11.6 |
| Used Test Bourne 9 | No | 31 | 26.88 | 695 | 15.12 |

Below in table 2 is listed experimental data using above method implementing a combination of rotational and linear movement of the wafer chuck and hence the wafer during deposition and different target (new) with a different target composition compared to that in table 1. The experimental data listed in table 2 is for the same experiment as illustrated in figure 10 illustrating the measured sheet resistance measured using a four-point probe. The variance (1-Sigma) is about 1.86 % which is a substantial improvement from the prior art as described in the Background of the Invention.

A uniform sheet resistance of 1.86% is achieved by implementing the combination of linear and rotational movement during the sputtering process.

**Table 2**

| | Avg | Std Dev | 1-Sigma | Min | Max |
|---|---|---|---|---|---|
| Rs (Ohm/sq) | 841844.81 | 15694.17 | 1.86426 | 808282.38 | 872275 |
| Res (Ohm-cm) | 2.525534 | 0.047083 | 1.86426 | 2.424847 | 2.616225 |
| Thk(um) | 0.03 | 0 | 0 | 0.03 | 0.03 |
| V/I | 215266.44 | 1433.30 | 0.665828 | 211234.48 | 217876.30 |

In one embodiment of the method the linear movement back and forth along the rail comprises multiple linear sub movements.

In one embodiment of the method the wafer is rotated around a rotational axis arranged in the wafer's centre perpendicular to the deposition surface.

In one embodiment of the method the wafer is rotated with the wafer centre moving along an orbital path in the rotational plane, said orbital path having a centre displaced from the wafer's centre.

In a further embodiment, the centre of the orbital plane is moved linearly along the rail.

In one embodiment of the method, the linear and the rotational movement is performed using a single drive unit.

In one embodiment of the method, the linear and the rotational movement is performed using a single drive unit.

One object of the invention is achieved by a wafer holding system for a magnetron sputter, wherein said system comprises:
- a wafer chuck slidable arranged on at least one rail;
- a drive system connected to the wafer chuck, said drive system being configured for moving the wafer chuck linearly back and forth along the rail and for rotating the wafer chuck,
wherein, when in use with the wafer arranged on the wafer chuck, the linear movement and the rotation of wafer chuck is in a rotational plane substantially parallel to a deposition surface of the wafer.

In one embodiment of the wafer holding system, the drive system comprises a motor and/or a gearing system such as a spindle, a gearwheel drive and/or a toothed rack.

In one embodiment of the wafer holding system, the drive system comprises two drive units adapted for performing respectively the linear movement and the rotational movement.

An object of the invention is achieved by a temperature control system for a wafer chuck. The system comprises:
- a wafer chuck,
- a wafer pedestal,
- a rod, preferably made of bronze,
- a fluid container,
- a contact block, and
- at least one rail, preferably two rails,

wherein said wafer chuck is assembled with the wafer pedestal, or wherein the wafer pedestal is an integrated part of the wafer chuck,
wherein the wafer chuck, when in use, is adapted for moving linearly back and forth on the least one rail,
wherein the rod is in contact with the fluid container, or wherein the rod forms a part of or is the fluid container, and
wherein the contact block is in contact with:
   the rod, and
   the wafer pedestal.

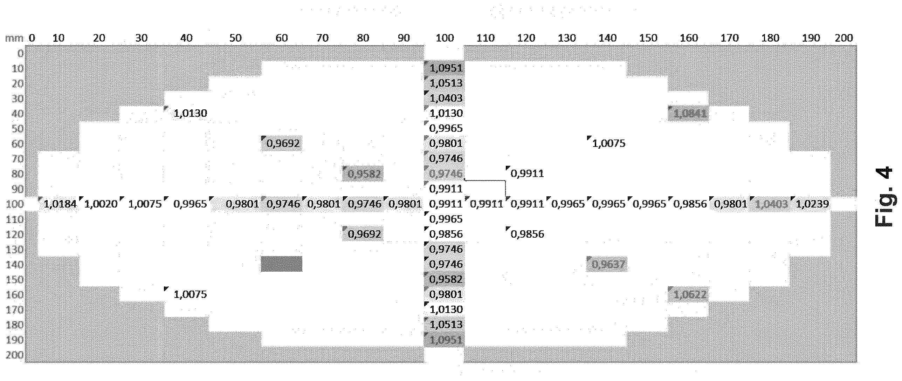

The linear movement of the wafer chuck limits the pattern effect from magnetron magnets as the wafer will move in relation to the magnetic field's lines similar to the drum solution described in the Background of the Invention. Figure 4 discloses a measured sheet resistance measured using a four-point probe. The figures disclose that the variance is about 4 % which is a substantial improvement from the prior art as described in the Background of the Invention.

The presented invention scales linearly with the diameter of the wafer compared to the drum solution. However, the linear movement can have a drawback compared to the drum solution as reliable temperature control can be needed along the linear movement of the wafer chuck.

It can thus be necessary to provide temperature control of the wafer during deposition. In prior art embodiments, where the wafer chuck is stationary a tube with a fluid cool or heat the wafer chuck. Since the wafer chuck is stationary then the tube is stationary, and the tube may be made of plastic.

In the embodiment according to the invention, the wafer chuck is moving linearly back and forth on the at least one rail. In theory, one could use a tube such as a bellow tube with a sufficient length, said tube would could then be attached to the wafer chuck, however the linearly back and forth movement would cause the tube to bend and cause the bend to move back and forth on the tube, thereby severely increasing the wear on the tube, which will cause a need for regular maintenance. The reduced production time due to maintenance would make such solutions not viable for commercial production.

The invention provides a reliable and less maintenance heavy solution by creating a heat transfer pathway from rod to contact block to the wafer pedestal to the wafer chuck. The wafer chuck will, when in use, be equipped with a wafer and thus the wafer is cooled or heated via the heat transfer pathway. The heat transfer pathway does not change as the wafer chuck is displaced back and forth along the temperature control system thereby the temperature control is constant and reliable.

Along the heat transfer pathway, the temperature control system may be equipped with heat transferring paste at intersections between components to maximise heat transfer and ensure a relative constant heat transfer.

In the embodiment, wherein the rod is in contact with the fluid container, there will be a temperature gradient along the rod wherein the temperature will be lower or higher at the end in contact with the fluid container and higher or lower in the other end. The wafer chuck will move back and forth relative to the rod and thus the cooling or heating will be sufficiently and relatively constant.

In the embodiments, wherein the rod forms a part of or is the fluid container, coolant is moving through the rod and thus the rod will have a more uniform temperature and since the heat transfer between the rod and the wafer chuck will be constant and independent of the wafer chuck's position relative to the rod.

The fluid container may comprise a pump and a passive heat pump or active heat pump for cooling or heating the fluid. Such passive and active heat pumps are well known. The required heat energy transfer is not very high for this system and thus liquid or gas can be used without any change of phase, but in some embodiments one can chose to have a heat transfer system with phase change. Liquid generally has higher heat capacity than gas and liquid is thus preferred in the present invention.

The length of the rod and the at least one rail depends on the size of the wafer. The wafer chuck should move through the depositing zone of the magnetron sputter with a constant speed thereby each area of wafer has the same period within the depositing zone. Thus, the rod and the at least one rail should have a length allowing the wafer chuck to be completely outside the depositing zone. Furthermore, the length must be so that the wafer chuck can change velocity outside of the depositing zone such that a constant velocity can be reach before entering the depositing zone.

In an embodiment, the contact block may be a metal graphite block. Metal graphite is very durable and have excellent heat-transferring characteristics. The durability ensures that the number of particles due to friction in the vacuum chamber is reduced compared to less durable materials.

In one embodiment, the metal graphite is 95 % Ag and 5 % graphite. The metal can be different, and the relative percentages can be varied as long as the resulting metal graphite block is still durable and has excellent heat-transferring characteristics.

The contact block may be of a different material than metal graphite provided that the different material has similar or close to similar characteristics to contact block.

In an embodiment, the system may further comprise a shield above the rod. The purpose of the shield is to shield the rod from thin film layers, which would otherwise accumulate over time resulting in a deteriorating heat transfer from the contact block to the rod.

The shield may have a width greater than the rod to better shield the rod. The shield may have a width which is 2-5 cm greater than the rod, such as 3 cm greater than the rod or 4 cm greater than the rod. In theory, the width can be even greater, but the shielding effect will not increase significantly after a certain width. The skilled person can determine the optimal width through tests.

In an embodiment, the wafer pedestal may comprise at least one heat transfer arm, or preferably at least two heat transfer arms, or more preferably four heat transfer arms. Heat transfer arms may be placed on each side of the wafer pedestal to increase the heat transfer rate.

To obtain a specific heat transfer value a specific cross-section area of the heat transfer arm or arms can be calculated. If there is only a single heat transfer arm, then said single heat transfer arm must have a cross-section area equal to said specific cross-section area. If there are two heat transfer arms, then each arm may have a cross-section area equal to half of said specific cross-section area, a different distribution is possible, but it will not simplify the resulting temperature control system. If there are four heat transfer arms then each arm may have a cross-section area equal to a quarter of said specific cross-section area, a different distribution is possible, but it will not simplify the resulting temperature control system.

A single heat transfer arm is sufficient for transferring heat provided, however at least two heat transfer arms are preferred as the two heat transfer arms can be positioned such that one heat transfer arm is positioned on each side of the wafer pedestal. Thereby, it becomes easier to balance forces.

Four heat transfer arms are most preferred, as it is easier to ensure good contact and thus better and more constant heat transfer, since a variance in the exact position of the heat transfer arm may cause part of the heat transfer arm to have poor contact and thus poor heat transfer. The risk of a poor contact area increases with the size of the heat transfer arm.

The plates are especially important for the embodiments wherein the rod comprises a shield, as they prevent heat transfer through the top of the rod. Thus, the heat transfer arms extend past the shield such that the contact blocks can engage the sides the rod.

The wafer pedestal may comprise more than four heat transfer arms such as five, six, or eight heat transfer arms or more.

In an embodiment, at least one of the at least two heat transfer arms may be connected to the wafer pedestal via a cylindrical bearing. Preferably all sides plates are connected to the wafer pedestal via cylindrical bearings.

The cylindrical bearings enable that the at least one heat transfer arm can adjust continuously in relation to a rotation axis such that the contact block is in contact with the rod to ensure a constant and reliable heat transfer. The cylindrical bearing will at the same time ensure that heat transfer arm makes any unwanted movement in other dimensions than what is mechanically allowed by the cylindrical bearing.

In an embodiment, the cylindrical bearing may define a rotation axis being substantially parallel with a longitudinal axis of the rod. Thereby the cylindrical bearing will only allow the at least one heat transfer arm to move towards or away from the rod. This will ensure the most reliable and constant heat transfer.

In an embodiment, at least one of the at least two heat transfer arms may be connected to the contact block by a spherical bearing. Preferably all heat transfer arms are connected to the contact blocks via spherical bearing. The spherical bearing enables that the contact block can adjust as need be, such that the contact area between the contact block and rod is maximised and as constant as possible. This will maximise heat transfer and ensure that the heat transfer is as constant as possible.

In an embodiment, the wafer chuck may comprise at least one wing, preferably two wings, with said wing being coupled to the rail or said wings being coupled to the rail.

The coupling may be a coupling to a sleigh on the rail wherein the sleigh is moved back on fourth on said rail. The sleigh may be coupled to a motor which displaces the sleigh using linear actuator or a track or band or endless band or similar solutions. Coupling may be mechanical or may utilise magnetic forces wherein the wing and the rail or sleight are connected via magnetic forces established between a permanent magnetic material and other magnetic material. The permanent magnetic material may be positioned on the sleigh, or with the wing and the other magnetic material being positioned complementary on the wing or the sleigh.

By using magnetic forces there will be no need for mechanical gripping between the rail and the wing. Thereby, it becomes easier to ensure a vacuum during use of the temperature control system when installed in a magnetron.

In an embodiment, the wafer pedestal may comprise at least one spring arrangement, preferably two spring arrangements, more preferably four spring arrangements. The at least one spring arrangement may be position between the cylindrical bearing and the contact block on the heat transfer arm and the at least one spring arrangement extends to the wafer pedestal. The spring arrangement extends towards the main body of the wafer pedestal.

The at least one spring arrangement being configured to create a biasing force from the heat transfer arm towards the wafer pedestal, such that the contact block is constantly forced towards the rod, which, in addition, enables that the spherical bearing can adjust to any changes.

In a preferred embodiment, the two-spring arrangement or more preferably the four spring arrangements may be positioned between the cylindrical bearing and the contact block on the heat transfer arm and the at least one spring arrangement extending to the wafer pedestal.

In an embodiment, the at least one spring arrangement may be a spring-loaded bolt as it will reliably ensure a biasing force towards the main body of the wafer pedestal.

In an embodiment, when in use, the fluid container may comprise a liquid. The liquid can be used for transferring heat to a heat pump from where it can be removed or transfer heat from the heat pump to the wafer chuck. The liquid may circulate the fluid container using a pump.

If the fluid container uses liquid, then the fluid container is a liquid container.

In an embodiment, the fluid may be a liquid, preferably water, or a gas. The fluid may change phase due to a heat pump however the coolant inside the rod is preferably in the liquid phase.

The required cooling or heating is not extreme, and water is therefore the preferred liquid. Furthermore, water has a high specific heat capacity, is non-toxic and reada-bly available. The water may include various additives.

If the purpose is to heat the wafer, then silicone oil or mineral oil may be used as a liquid.

In an embodiment, the fluid may be 0.1 to 40 degrees Celsius, preferably between 10 to 30 degrees Celsius, more preferably between 15 to 25 degrees Celsius, most preferably 20 degrees Celsius or 60 to 100 degrees Celsius, or 90-100 degrees Celsius or 120-150 degrees Celsius.

Tests have demonstrated that the above-mentioned temperature ranges are sufficient for cooling or heating the wafer positioned on the wafer chuck during normal use.

In an embodiment, the fluid container may comprise a fluid inlet, and a fluid outlet. The fluid inlet and the fluid outlet can be positioned in one end of the rod or in opposite ends.

In an embodiment, the system may further comprise at least one sensor positioned at the wafer chuck. The at least one sensor may be configured to measure a temperature.

In an embodiment, the system further comprises at least one sensor positioned at the fluid container. The at least one sensor may be configured to measure a temperature.

The system may be configured to increase or decrease heat transfer as a function of a sensor at the fluid container and/or the wafer chuck. The temperature at the wafer chuck is the most important data, however there could be additional temperature sensors along the heat transfer pathway. The system may include or decrease the heat transfer as a function of sensor data.

An object of the invention is achieved by a magnetron sputter comprising a vacuum chamber, a linear target holder, and the temperature control system according to the invention, wherein the target holder and the temperature control system are positioned inside the vacuum chamber such that the temperature control system extends on both sides of the target holder. The temperature control system extends on both sides of the target holder, i.e. both sides of the target during use by the rod and rail enabling the wafer chuck to be displaced to either side of the target holder. If the target is projected onto the rod, then the wafer (during use) and the projected target will not overlap in all positions.

Alternatively, an object of the invention is achieved by the above disclosed magnetron sputter comprising the wafer holding system.

In one embodiment, the magnetron sputter comprises a vacuum chamber, a linear target holder and a temperature control system, wherein the target holder and the temperature control system are positioned inside the vacuum chamber such that the temperature control system extends on both sides of the target holder, said temperature control system comprises:
- the wafer holding system,
- a wafer pedestal,
- a rod, preferably made of bronze,
- a fluid container, and

a contact block, wherein said wafer chuck is assembled with the wafer pedestal, or wherein the wafer pedestal is an integrated part of the wafer chuck,
wherein the wafer chuck, when in use, is adapted for moving linearly back and forth on the at least one rail,
wherein the rod is in contact with the fluid container, or wherein the rod forms a part of or is the fluid container, and
wherein the contact block is in contact with:
   - the rod, and
   - the wafer pedestal.

The magnetron sputter will in effect be a line scanner where the wafer chuck with the wafer will pass the target holder and thus the linear target holder must hold a linear target during use such that the depositing is uniform.

In order to achieve a sufficient uniform deposition, the wafer should move at a constant speed past the wafer and hence move at a constant speed through the physical vapor. Thus, the rod and rail should have a length such that the wafer chuck is out of the physical vapour in each end to avoid an uneven deposition during change of velocity vector of the wafer chuck. Furthermore, there should be sufficient distance for the wafer chuck to reach a constant velocity before entering the physical vapor. Thus, the magnetron sputter must have a two acceleration zones on each side of a deposition zone with physical vapor during use of the magnetron sputter. In each acceleration zone, the wafer chuck and thus the wafer will accelerate to a standstill and accelerate to a constant velocity in the opposite direction.

The magnetron sputter comprises all the known features of a magnetron sputter for sputter deposition including a voltage source, and a power source. The voltage source may be a RF source or a DC source or pulsed DC source or any other suitable voltage source.

The target material may be TFT (thin-film transistor) material as the magnetron sputter has demonstrated during testing to be able to deposit TFT material with a more uniform sheet resistance compared to the prior art solutions. The invention is however not limited to thin-film transistor material as other thin films will also achieve a more uniform thin-film characteristics as an example the thin-film may be a piezo electric thin film as the piezo characteristics improves by improved uniformity.

The target material may be metal compound containing oxides or metal compound containing nitrides or metal compound oxides and nitrides or metal compound carbides or metal compound oxides and nitrides and carbides. The compounds containing oxides, nitrides and carbides have been shown to be affected by the magnetic field resulting in a very large variance in sheet resistance across the wafer, however said variance has been reduced significantly by the present invention.

The target material may be lead zirconate titanate as a thin film of lead zirconate titanate which can be used as a piezo electric thin film. The piezo electric characteristics will also be affected by variance in the sheet resistance.

The target material may be NbxTi(1-x)N with 0.5 < x < 0.8, which material is used as an interconnect for nodes smaller than 4 nm such as 2 nm or 1.8 nm or 1.4nm, or used as a superconductive interconnect. The quality of the interconnect is affected by the sputtering process as the sheet resistance and the critical temperature becomes more uniform by use of the magnetron sputter according to the invention.

An object of the invention is achieved by a method for sputter deposition using a magnetron sputter, the magnetron sputter preferably comprising the temperature control system according to the invention. The magnetron sputter may be according to the invention. Said method comprising the steps:
- establishing a vacuum zone in a vacuum chamber,
- providing a wafer chuck comprising a wafer pedestal,
- providing a rail, wherein said wafer pedestal is movable on the rail,
- providing a rod extending parallel to the rail,
- providing a fluid container with a coolant,
- sputtering target material onto a wafer positioned on the wafer chuck,
- moving the wafer chuck linearly back and forth on the rail, while ensuring contact between the wafer pedestal and the rod via a contact block.

The steps of sputtering and moving are performed while performing a step of heat transfer of the wafer chuck along a heat transfer pathway by:
- heat transferring between the fluid container and the rod by using the fluid as a convection medium,
- heat transferring between rod and the contact block by conduction,
- heat transferring between the contact block and the wafer pedestal by conduction, and
- heat transferring between the wafer pedestal and the wafer chuck by conduction.

The steps of the method can be executed in any order and/or executed simultaneously.

The above disclosed method for sputter deposition using a magnetron sputter, may be performed using any one of the embodiments of the magnetron sputter disclosed herein.

The resulting thin film will have a smaller variance of sheet resistance as can be seen from the data presented in figure 4 or figure 10. Figure 4 has been normalized. Figure 4 discloses a normalized sheet resistance, but a figure showing resistivity would show the same low variance.

In an embodiment, the method may comprise the step of establishing a fluid flow in a fluid container comprising a fluid inlet and a fluid outlet.

In an embodiment, the method may comprise the step of establishing a fluid flow through the rod. The rod may have an internal channel through which the fluid is moved.

In an embodiment, the method may further comprise the step of:
- measuring a temperature of the fluid, and/or
- measuring a temperature of the wafer chuck.
wherein the measurements preferably are obtained by one or more sensors. The method may have additional sensors along the heat transfer pathway for measuring the heat transfer.

In an embodiment, the method may further comprise the step of controlling a flow rate of the fluid flow based on the one or more measurements of the temperature of the coolant sand/or wafer chuck.

The herein disclosed methods and apparatuses with the temperature control and the wafer holding system achieving a combination of linear and rotational movements may be combined for optimal operation.

### Description of the Drawing

Embodiments of the invention will be described in the figures, whereon:
Fig. 1 illustrates a cross section of the magnetron sputter;
Fig. 2 illustrates an embodiment of the temperature control system;
Fig. 3 illustrates an embodiment of the wafer pedestal; and
Fig. 4 discloses a normalized sheet resistance of a TFT layer deposited in a magnetron sputter according to the invention;
Fig. 5 illustrates a schematic of zones of the magnetron sputter;
Fig. 6 illustrates a magnetron sputter with the target holder and the zones.
Figs. 7 and 8 illustrates a magnetron sputter with the wafer holding system.
Fig. 9 illustrates movements achievable with the wafer holder.
Fig. 10 discloses a normalized sheet resistance of metal oxide layer deposited in a magnetron sputter according to the invention.

### Detailed Description of the Invention

| **Item** | **No** |
|---|---|
| Temperature control system | 1 |
| Wafer chuck | 10 |
| Wing | 17 |
| Wafer pedestal | 20 |
| Heat transfer arm | 25 |
| Cylindrical bearing | 27 |
| Spherical bearing | 29 |
| Rail | 30 |
| Rod | 40 |
| Shield | 45 |
| Fluid container | 50 |
| Fluid flow | 55 |
| Fluid flow | 56 |
| Contact block | 60 |
| Spring arrangement | 80 |
| Wafer | 90 |
| Deposition surface | 92 |
| Magnetron sputter | 100 |
| Vacuum chamber | 110 |
| Target holder | 120 |
| Rotational plane | 122 |
| Rotational axis | 124 |
| Acceleration zone | 130A,130B |
| Deposition zone | 140 |
| Velocity profile | 200 |
| Drive system | 210 |
| Wafer holding system | 1000 |

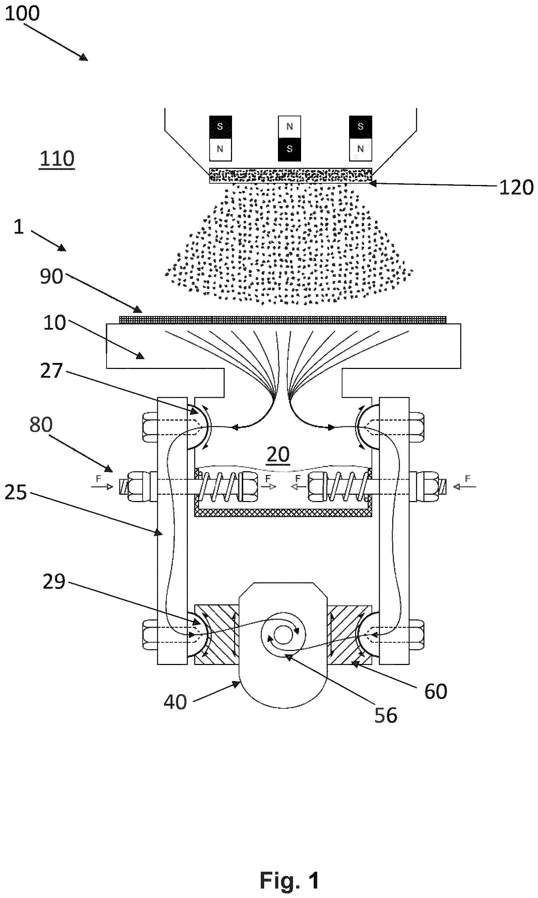

Fig. 1 illustrates a cross section of the magnetron sputter 100. The magnetron sputter 100 comprises a vacuum chamber 110, a target holder 120, and a temperature control system 1, wherein the target holder and the temperature control system are positioned inside the vacuum chamber 110. The target holder 120 holds a target and magnets are schematically shown above the target holder 120. The temperature control system 1 is equipped with a wafer 90. In the figure, the sputter deposition is shown with several dots between the target holder 120 and the wafer 90. The magnetron sputter 100 is with the exception of the temperature control system 1 a conventional magnetron sputter 100 with the well-known features such as RF source, power source, vacuum pump, and so on. These features of the magnetron sputter 100 will not be discussed further as the features are well-known to the skilled person. The vacuum chamber 110 should be large enough to allow displacement of the wafer 90 within the vacuum chamber 110 in relation to the target holder 120. Preferably, the temperature control system 1 extend on both sides of the target holder 120 such that the wafer 90 can be displaced to both side of the target holder 120 or to both sides of the target held by the target holder 120.

The temperature control system 1 comprises a wafer chuck 10 onto which the wafer 90 is positioned. The wafer chuck 10 is mechanically connected to a fluid container via a heat transfer path for cooling or heating the wafer 90. The heat transfer path is shown in the figure with several arrows. The wafer chuck 10 is assembled with a wafer pedestal 20.

The wafer chuck 10 is, when in use, adapted for moving linearly back and forth on at least one (not shown) rail 30. The at least one rail 30 is shown in figure 2.

The wafer pedestal 20 comprises at least two heat transfer arms 25 (two is shown), wherein the at least two heat transfer arms 25 are connected to the wafer pedestal 20 via a cylindrical bearing 27 such that the heat transfer arms 25 can pivot relative to an axis.

Each of the two heat transfer arms 25 are connected to contact blocks 60 via spherical bearings 29 such that the contact blocks 60 can adjust freely. The contact blocks 60 are preferably graphite blocks.

The contact blocks 60 are in contact with a rod 40 being integrated with a fluid container 56 running along the rod 40 and the spherical bearings 29 enable maximized contact area between the rod 40 and the contact block. The fluid container 56 may have a pump or a fluid reservoir outside of the vacuum chamber. The fluid container may comprise a fluid in the form of a gas or preferably a liquid or combination. The required coolant effect is not great and in many applications, water can be used for cooling the wafer 90, such as room temperature water or liquid water between 0-50 degrees Celsius or 10-40 degrees Celsius or 15-30 degrees Celsius or 20 degrees Celsius.

The fluid container 50 may comprise a central cylinder within the rod 40 acting as a coolant inlet and an outer cylinder within the rod 40 having the central cylinder within. The outer cylinder acts as the outlet through which the coolant will exit the rod 40 and out of the magnetron sputter 100, thereby removing heat.

Furthermore, the wafer pedestal 20 comprises two shown spring arrangements, wherein the two spring arrangements 80 are positioned between the cylindrical bearing 27 and the contact block 60 on the heat transfer arm 25, with the two spring arrangements 80 extending to the wafer pedestal 20. The spring arrangements 80 maintain a biasing force towards the wafer pedestal 20 and thus constantly force the blocks 60 into contact with the rod 40. The cylindrical bearings 27 and spherical bearings 29 help ensure that the contact surface is maximized and maintained.

Although not shown, the different parts will in most embodiments be provided with a heat transfer path to maximise heat transfer.

Fig. 2 illustrates an embodiment of the temperature control system 1. Figure 2A discloses the temperature control system 1 without rails 30 and figure 2B discloses the temperature control system 1 with rails 30. The temperature control system 1 comprises a wafer chuck 10 onto which a wafer 90 is positioned throughout. The wafer chuck 10 is mechanically connected to a fluid container 50 in a rod 40, which fluid container 50 comprises a fluid flow 56. The rod 40 is shown and described in more detail in figure 1.

The rod is equipped with a shield 45 to prevent deposition on the rod 40 as deposition will limit the heat transfer efficiency.

The wafer pedestal 20 is not disclosed in great detail, but the wafer pedestal 20 is identical to the embodiments disclosed in figure 1 and 2.

The wafer chuck 10 comprises two wings 17. In the present embodiment, each wing 17 is adapted to be connected to a sleigh. Each sleigh is displaceable along one of the two rails 30 shown in figure 2B.

The wafer chuck 10 and thus the wafer 90 will move back and forth along the rod 40 during deposition as shown in figure 1, while being cooled. The resulting thin film layer will have a very uniform sheet resistance.

A single motor is displacing each sleigh along the two rails 30, the motor is operationally connected to each sleigh via gears and a single belt such that the sleighs move in unison. The temperature control system 1 could have two motors each being operationally connected to each sleigh and then ensuring unison by precise controlling, however, it will be more difficult than the shown solution.

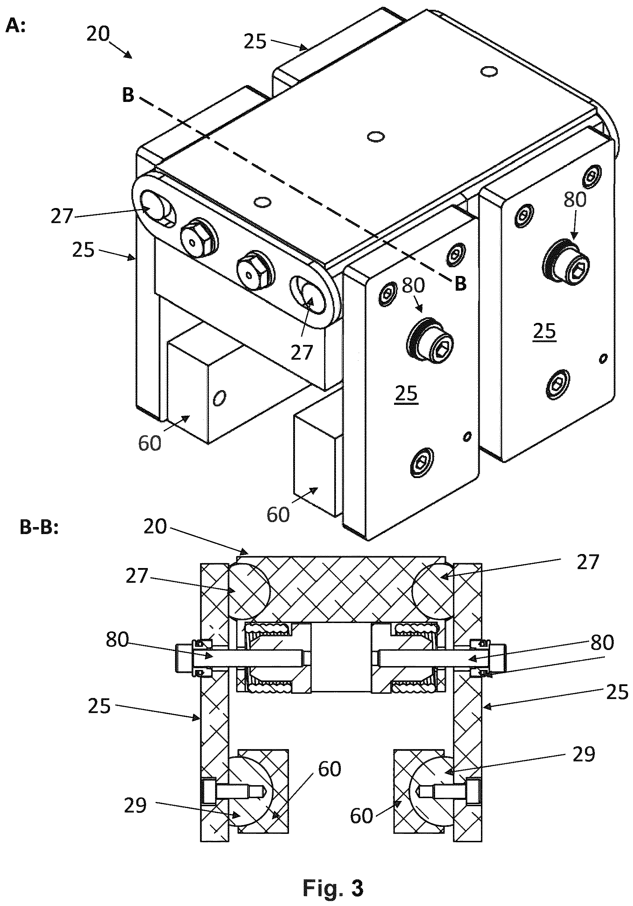

Fig. 3A illustrates an embodiment of the wafer pedestal 20 and figure 3B-B illustrates along the B-B line.

The wafer pedestal 20 comprises four heat transfer arms 25, wherein each of the four heat transfer arms 25 are connected to the wafer pedestal 20 via a cylindrical bearing 27 such that the heat transfer arms 25 can pivot relative to an axis.

Each of the two heat transfer arms 25 are connected to contact blocks 60 via spherical bearings 29 such that the contact block 60 can adjust freely. The contact blocks 60 are preferably graphite blocks. The contact blocks 60 will during use be in contact with a rod 40.

Furthermore, the wafer pedestal 20 comprises four spring arrangements 80, wherein the four spring arrangements 80 are positioned between the cylindrical bearing 27 and the contact block 60 on the heat transfer arm 25. The four spring arrangements 80 extend from the heat transfer arms 25 to the wafer pedestal 20. The spring arrangements 80 maintain a biasing force towards the wafer pedestal 20 and thus constantly force the blocks 60 into contact with the rod 40. The cylindrical bearings 27 and spherical bearings 29 help ensure that the contact surface between the blocks 60 and the rod is maximized.

Fig. 4 illustrates the sheet resistance of a thin film layer deposited in a magnetron sputter 100 according to the invention.

The data show that the resulting thin film layers have a very uniform sheet resistance, thereby the magnetron sputter 100 solve the object of the invention.

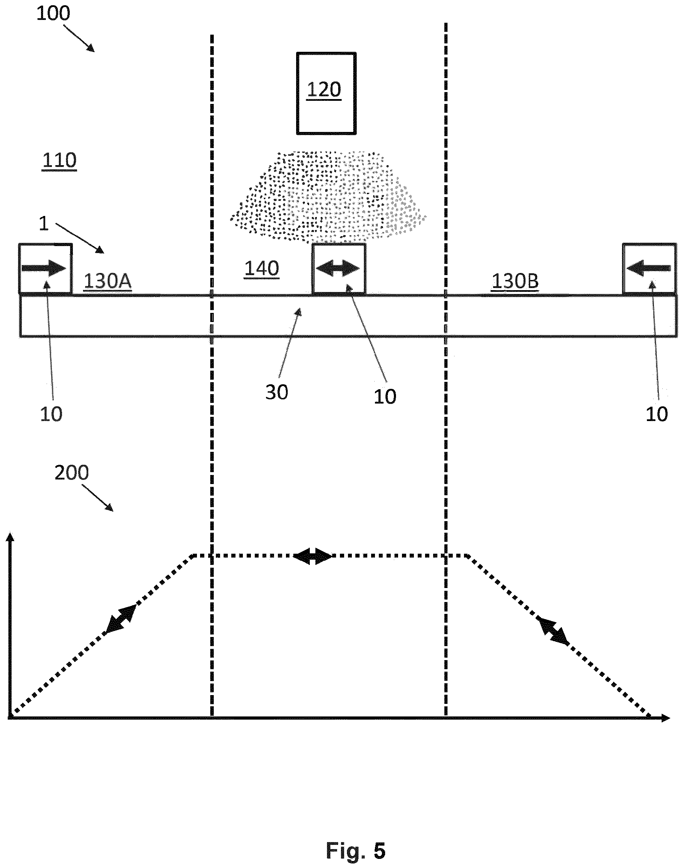

Fig. 5 illustrates zones of the magnetron sputter 100 schematically. The magnetron sputter 100 comprises a vacuum chamber 110, a target holder 120 and the temperature control system 1 according to present invention, wherein the target holder 120 and the temperature control system 1 are positioned inside the vacuum chamber 110 such that the temperature control system 1 extends on both sides of the target holder 120. Thereby, a line scan can be performed.

The wafer chuck 10 is displaced along the rails 30. The same wafer chuck 10 is shown in opposite ends and at a position below the target holder 120. The arrows inside the wafer chuck 10 are to show in which direction the wafer chuck 10 can move.

The vacuum chamber 110 has three zones. Two acceleration zones 130A, 130B in opposite ends where the wafer chuck 10 and thus the wafer 90 (not shown) can change velocity. There is no or only minor depositing of material in these zones 130A, 130B since depositing in these zones 130A,130B would cause uneven depositing due to the change in velocity. The lower part of the figure shows a velocity profile 200 with position out the first axis and velocity up the second axis.

The velocity profile is in the acceleration zones 130A, 130B illustrated as a straight line but the velocity profile could have any shape as long as the wafer chuck 10 has a constant velocity when moving inside a depositing zone 140 which will have physical vapor during use of the magnetron sputter 100. The velocity profile shows that the velocity is constant over the entire depositing zone 140.

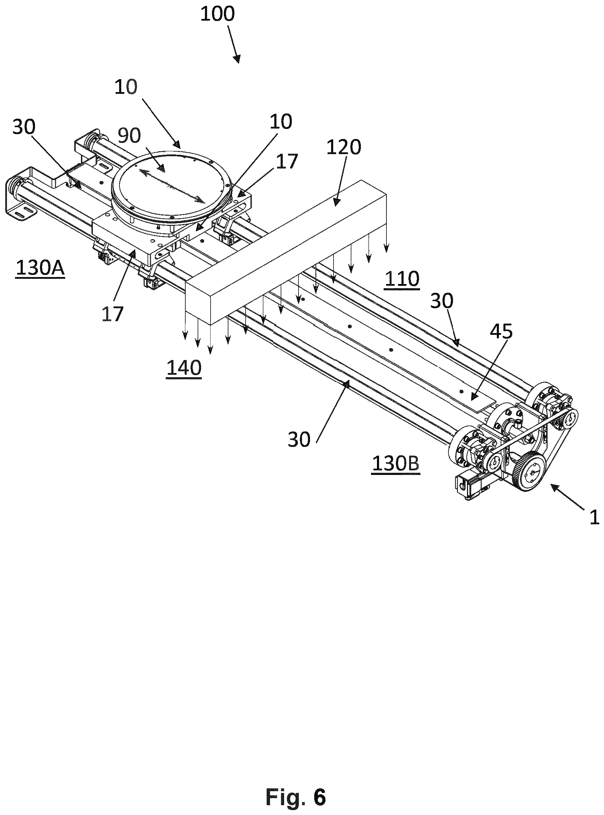

Fig. 6 illustrates a magnetron sputter 100 with the target holder 120 and the zones (130A, 130B, 140).

The magnetron sputter 100 comprises a vacuum chamber 110, a target holder 120 and the temperature control system 1 according to present invention, wherein the target holder 120 and the temperature control system 1 are positioned inside the vacuum chamber 110 such that the temperature control system 1 extends on both sides of the target holder 120. Thereby, a line scan can be performed.

The wafer chuck 10 is displaced along the rails 30. The same wafer chuck 10 is shown in opposite ends and at a position below the target holder 120. The arrows inside the wafer chuck 10 are to show in which direction the wafer chuck 10 can move.

The vacuum chamber 110 has three zones in order to achieve a uniform deposition. Two acceleration zones 130A, 130B in opposite ends where the wafer chuck 10 and thus the wafer 90 can change velocity. There is preferably no deposition or only miniscule depositing of material in these zones 130A, 130B since depositing in these zones 130A,130B would cause uneven depositing due to the change in velocity. The physical vapor deposition is in the figure indicated by rows of arrows extending downwardly from the target holder 120, which holds a target. The plasma generation is performed using well known means.

The velocity profile in the acceleration zones 130A, 130B can in theory be any velocity profile since there is no material depositing or at least very close to no material depositing so the velocity profile in the acceleration zones 130A, 130B does not affect the depositing of material onto the wafer 90. However, the velocity profile of the wafer chuck 10 must be a constant when moving inside a depositing zone 140 which will have physical vapor during use of the magnetron sputter 100. In order to achieve constant velocity in the depositing zone 140, the magnetron sputter will be designed such that the wafer chuck 10 will reach a constant velocity in the acceleration zones 130A, 130B prior to entering the depositing zone 140.

The resulting sheet resistance of a deposited conductive layer has a variance of 4 % compared to prior art solutions where the sheet resistance of a deposited conductive layer can vary by a factor of 4 and in some embodiments by a factor of 10.

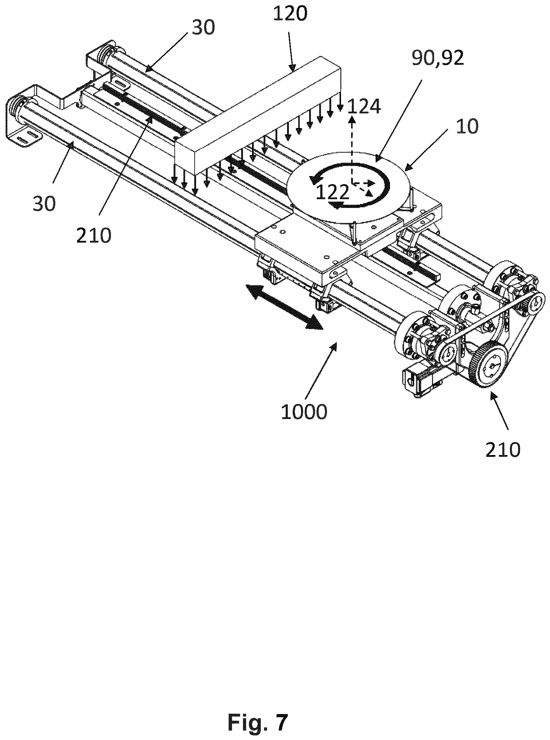

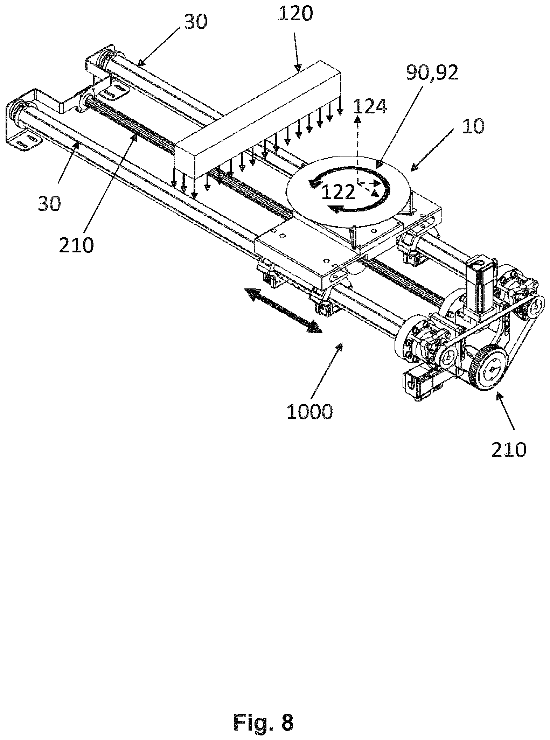

Figs. 7 and 8 illustrate a wafer holding system (1000) for a magnetron sputter. The system comprises
- a wafer chuck 10 slidable arranged on two rails 30, and
- a drive system 210 connected to the wafer chuck.
The drive system is configured for moving the wafer chuck linearly back and forth along the rails 30 and for rotating the wafer chuck, as illustrated with the bold arrows.

When in use the wafer is arranged on the wafer chuck, and the linear movement and the rotation of wafer chuck is in a rotational plane 122 substantially parallel to a deposition surface 92 of the wafer 90. The wafer is rotated around a rotational axis 124.

The rotational axis may preferably be arranged in the wafer's centre as illustrated in both fig. 7 and fig. 8.

The embodiments illustrated in figs. 7 and 8 implement two different drive systems 210. Fig. 7 illustrates a rotation coupled with translation, which is achieved by use of the toothed rack arranged in the middle between the rails 30. Fig. 8 illustrates a drive system wherein the rotation of the wafer chuck is decoupled from translation. An additional motor at the front, drives a spline shaft which transfers to the wafer chuck. These are merely for illustrative purposes and to illustrate that the linear and rotational movement can be coupled or decoupled form each other.

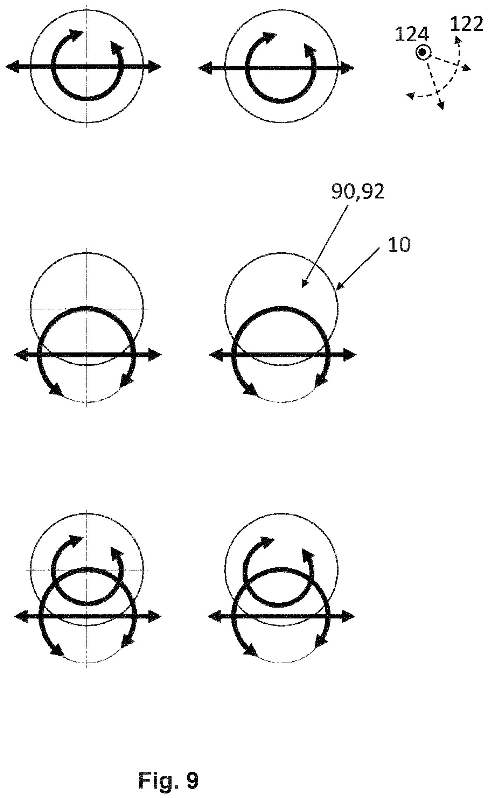

Fig. 9 illustrates alternative movement patterns of the wafer chuck and hence the wafer, which may be achieved with the wafer holder system. The patterns may include that

Top: the wafer is rotated around a rotational axis in the wafer's centre in combination with the linear movement.

Middel: The wafer is rotated around a rotational axis displaced from the wafer's centre in combination with the linear movement.

Bottom: A combination of the two other rotational movement patterns and the linear movement.

Fig. 10 discloses a measured sheet resistance measured using a four-point probe. The figures disclose that the variance is about 1.8 % which is a substantial improvement from the prior art as described in the Background of the Invention.

### ITEMS

Item 1. A temperature control system (1) for a wafer chuck, wherein said system comprises:
- a wafer chuck (10),
- a wafer pedestal (20),
- a rod (40), preferably made of bronze,
- a fluid container (50),
- a contact block (60), and
- at least one rail (30), preferably two rails,

wherein said wafer chuck (10) is assembled with the wafer pedestal (20), or
wherein the wafer pedestal (20) is an integrated part of the wafer chuck (10),
wherein the wafer chuck (10), when in use, is adapted for moving linearly back and forth on the at least one rail (30),
wherein the rod (40) is in contact with the fluid container (50), or wherein the rod (40) forms a part of or is the fluid container (50), and
wherein the contact block (60) is in contact with:
   - the rod (40), and
   - the wafer pedestal (20).

Item 2. A temperature control system (1) according to item 1, wherein the contact block (60) is a metal-graphite block.

Item 3. A temperature control system (1) according to item 1 or 2, wherein the system further comprises a shield (45) above the rod (40).

Item 4. A temperature control system (1) according to any of the preceding items, wherein the wafer pedestal (20) comprises at least one heat transfer arm (25), or preferably at least two heat transfer arms (25), more preferably four heat transfer arms (25).

Item 5. A temperature control system (1) according to item 4, wherein at least one of the at least two heat transfer arms (25) is connected to the wafer pedestal (20) via a cylindrical bearing (27).

Item 6. A temperature control system (1) according to item 5, wherein the cylindrical bearing (27) defines a rotation axis being substantially parallel with a longitudinal axis of the rod (40).

Item 7. A temperature control system (1) according to anyone of items 4 to 6, wherein at least one of the at least two heat transfer arms (25) is connected to contact block (60) by a spherical bearing (29).

Item 8. A temperature control system (1) according to any of the preceding items, wherein the wafer chuck comprises at least one wing (17), preferably two wings, wherein said wing is coupled to the rail (30).

Item 9. A temperature control system (1) according to any of the preceding items, wherein the wafer pedestal (20) comprises at least one spring arrangement (80), preferably two spring arrangements, more preferably four spring arrangements, wherein the at least one spring arrangement (80) is positioned between the cylindrical bearing and the contact block on the heat transfer arm and the at least one spring arrangement (80) extending to the wafer pedestal (20).

Item 10. A temperature control system (1) according to item 8, wherein the at least one spring arrangement (80) is a spring-loaded bolt.

Item 11. A magnetron sputter (100) comprising a vacuum chamber (110), a linear target holder (120) and the temperature control system (1) according to any of the preceding items, wherein the target holder and the temperature control system are positioned inside the vacuum chamber (110) such that the temperature control system (1) extends on both sides of the target holder (120).

Item 12. A method for sputter deposition using a magnetron sputter (100), the magnetron sputter (100) preferably comprising the temperature control system (1) according to any of the preceding items, said method comprising the steps:
- establishing a vacuum zone in a vacuum chamber (110),
- providing a wafer chuck (10) comprising a wafer pedestal (20),
- providing a rail (30), wherein said wafer pedestal (10) is movable on the rail,
- providing a rod (40) extending parallel to the rail,
- providing a fluid container (50) with a coolant (55),
- sputtering target material (90) onto a wafer (90) positioned on the wafer chuck (10),
- moving the wafer chuck (10) linearly back and forth on the rail (30), while ensuring contact between the wafer pedestal (20) and the rod (40) via a contact block (60);
wherein the steps of sputtering and moving are performed while performing a step of heat transfer of the wafer chuck (10) along a heat transfer pathway by:
- heat transferring between the fluid container (50) and the rod (40) by using the coolant as a convection medium,
- heat transferring between rod (40) and the contact block (60) by conduction,
- heat transferring between the contact block and the wafer pedestal (20) by conduction, and
- heat transferring between the wafer pedestal and the wafer chuck (10) by conduction.

Item 13. A method according to item 12, wherein the method further comprises the step of:
- establishing a fluid flow (55) in a fluid container (50) comprising a fluid inlet and a fluid outlet.

Item 14. A method according to item 12 or 13, wherein the method further comprises the step of:
- establishing a fluid flow (55) through the rod (40).

Item 15. A method for magnetron sputtering according to any of items 12 to 14, wherein the target material is chosen amongst a metal compound oxides or a metal compound nitrides or a metal compound oxides nitrides, or a metal compound carbides or a metal compound oxides nitrides carbides.

## Claims

1. A method for sputter deposition using a magnetron sputter (100) with a target, said method comprising the acts of:
- establishing a vacuum zone in a vacuum chamber (110), and in the vacuum zone:
- providing a wafer chuck (10) slidable arranged on at least one rail (30);
- arranging a wafer (90) with a deposition surface (92) on the wafer chuck (10) with said deposition surface (92) facing the target;
wherein the wafer chuck (10) is configured for rotating the wafer in a rotational plane (122) substantially parallel to the deposition surface (92) and wherein the method comprises an act of
- sputtering target material onto the wafer (90) when arranged on the wafer chuck (10), while rotating the wafer and moving the wafer chuck (10) linearly back and forth along the rail (30) in a direction substantially parallel to the rotational plane.

2. The method according to claim 1 wherein the linear movement back and forth along the rail comprises multiple linear sub movements.

3. The method according to claim 1 or 2 wherein the wafer is rotated around a rotational axis (124) arranged in the wafer's centre perpendicular to the deposition surface (92).

4. The method according to any one of the preceding claims, wherein the wafer is rotated with the wafer centre moving along an orbital path in the rotational plane, said orbital path having a centre displaced from the wafer's centre.

5. The method according to claim 4 wherein the centre of the orbital plane is moved linearly along the rail.

6. The method according to any one of the preceding claims wherein the linear and the rotational movement is performed using a single drive unit.

7. The method according to any one of the preceding claims wherein the linear and the rotational movement is performed using a single drive unit.

8. The method according to any one of the preceding claims, wherein the target material is chosen amongst a metal compound oxides or a metal compound nitrides or a metal compound oxides nitrides, or a metal compound carbides or a metal compound oxides nitrides carbides.

9. A wafer holding system (1000) for a magnetron sputter (100), wherein said system comprises:
- a wafer chuck (10) slidable arranged on at least one rail (30);
- a drive system (210) connected to the wafer chuck, said drive system being configured for moving the wafer chuck linearly back and forth along the rail (30) and for rotating the wafer chuck,
wherein, when in use with the wafer arranged on the wafer chuck, the linear movement and the rotation of wafer chuck is in a rotational plane (122) substantially parallel to a deposition surface (92) of the wafer (90).

10. The wafer holding system (1000) according to claim 9, wherein the drive system comprises a motor and/or a gearing system such as a spindle, a gearwheel drive and/or a toothed rack.

11. The wafer holding system (1000) according to claim 9 or 10, wherein the drive system comprises two drive units adapted for performing respectively the linear movement and the rotational movement.

12. A magnetron sputter (100) comprising a vacuum chamber (110), a linear target holder (120) and a temperature control system, wherein the target holder and the temperature control system are positioned inside the vacuum chamber (110) such that the temperature control system (1) extends on both sides of the target holder (120), said temperature control system (1) comprises:
- the wafer holding system (1000) according to any of claims 9-11,
- a wafer pedestal (20),
- a rod (40), preferably made of bronze,
- a fluid container (50), and
a contact block (60), wherein said wafer chuck (10) is assembled with the wafer pedestal (20), or wherein the wafer pedestal (20) is an integrated part of the wafer chuck (10),
wherein the wafer chuck (10), when in use, is adapted for moving linearly back and forth on the least one rail (30),
wherein the rod (40) is in contact with the fluid container (50), or wherein the rod (40) forms a part of or is the fluid container (50), and
wherein the contact block (60) is in contact with:
- the rod (40), and
- the wafer pedestal (20).

13. A method for sputter deposition using the magnetron sputter (100) according to claim 12, said method comprising the steps:
- establishing a vacuum zone in a vacuum chamber (110),
- providing a wafer chuck (10) comprising a wafer pedestal (20),
- providing a rail (30), wherein said wafer pedestal (10) is movable on the rail,
- providing a rod (40) extending parallel to the rail,
- providing a fluid container (50) with a coolant (55),
- sputtering target material (90) onto a wafer (90) positioned on the wafer chuck (10),
- moving the wafer chuck (10) linearly back and forth on the rail (30), while ensuring contact between the wafer pedestal (20) and the rod (40) via a contact block (60);
wherein the steps of sputtering and moving are performed while performing a step of heat transfer of the wafer chuck (10) along a heat transfer pathway by:
- heat transferring between the fluid container (50) and the rod (40) by using the coolant as a convection medium,
- heat transferring between rod (40) and the contact block (60) by conduction,
- heat transferring between the contact block and the wafer pedestal (20) by conduction, and
heat transferring between the wafer pedestal and the wafer chuck (10) by conduction.

14. The method according to claim 13, wherein the method comprises one or more acts of the method according to any one of claims 1-8.

15. The magnetron sputter (100) according to claim 12 configured for performing the method according to any one of claims 1-8 or 13-14.
